# EUROPEAN PATENT APPLICATION

(11) **EP 2 426 658 A1**
(43) Date of publication of application: **07.03.2012**
(21) Application number: 10769620.5
(22) Date of filing: 15.04.2010
(51) Int. Cl.: G09F 9/30, G09F 9/40, H01L 51/50

(54) **LIGHT EMITTING DISPLAY APPARATUS**

(30) Priority: 28.04.2009 JP 2009109043
(71) Applicant: Nippon Seiki Co., Ltd., Niigata 940-8580 (JP)
(72) Inventor: CHOU, Raiei, Nagaoka Niigata (JP); SAKAI, Kazunori, Nagaoka Niigata (JP); MATSUMOTO, Yukio, Nagaoka Niigata (JP)
(74) Representative: Jackson, Richard Eric
(86) International application number: PCT/JP2010/056732
(87) International publication number: WO 2010/125921

(57) **Abstract**

To provide a light-emitting display apparatus having a curved display face which can be manufactured with ease and high yield. The light-emitting display apparatus includes a curved and light-transmitting substrate 1 and a flat light-emitting display panel 2. The light-emitting display panel 2 is placed and fixed onto a curved face 1b of the substrate 1. A plurality of the light-emitting display panels 2 are arranged side by side on the curved face 1b. An outer peripheral portion of the light-emitting display panel 2 on the side of a display face is bonded to the curved face 1b through an adhering member 3. The adhering member 3 is a light-shielding member.

## Description

### Technical Field

The present invention relates to a light-emitting display apparatus having a curved display face.

### Background Art

In recent years, research and development have been conducted at various places on a light-emitting display apparatus having an organic EL panel provided by forming an organic EL element, which is a self-emitting element, on a support substrate since such a light-emitting display apparatus is regarded as a next-generation light-emitting display apparatus due to its advantages such as a lower dependence on viewing angle, a higher contrast ratio, and the possibility of a smaller thickness as compared with a liquid crystal display apparatus.

A light-emitting display apparatus having a curved display face is desired for the purpose of improving the flexibility in the site of installation place or marketability. A conventionally known method to realize the light-emitting display apparatus having a curved display face is to curve and attach a flexible organic EL panel to a substrate having a curved face. A known method for providing such a flexible organic EL panel is to use a flexible resin substrate for a support substrate and a sealing plate (see, for example, Patent Document 1) or to make a support substrate and a sealing plate made of glass material extremely thin to 50 µm to 100 µm to render them flexible (see, for example, Patent Document 2).

### Prior Art Reference

### Patent Documents

Patent Document 1: JP-A-2003-19745
Patent Document 2: JP-A-2008-58489

### Disclosure of the Invention

### Problems that the Invention is to Solve

In the above mentioned methods, however, the high technology is needed to perform deposition on the resin substrate or to make the glass substrate extremely thin, and manufacture cannot be achieved. The above mentioned method using the resin substrate has problems of durability and productivity in that the flexible resin substrate often has the property of passing moisture and gas such as oxygen and thus has a disadvantage in the durability, and to address this, the formation of a gas barrier layer is needed to add a manufacture step. On the other hand, in the method of extremely thinning the glass substrate, the risk of glass break is very high and handling is significantly difficult, so that the method has a problem of low yield which prevents the panel from being mass-produced easily. Thus, there is still scope for improvement in order to allow easier manufacture of the light-emitting display apparatus having a curved display face.

The present invention has been made in view of the above mentioned problems, and it is an object thereof to provide a light-emitting display apparatus having a curved display face which can be manufactured with ease and high yield.

### Means for Solving the Problems

To solve the above mentioned problems, the present invention is characterized by including a curved and light-transmitting substrate and a flat light-emitting display panel and is **characterized in that** the light-emitting display panel is placed and fixed onto a curved face of the substrate.

The present invention is **characterized in that** a plurality of the light-emitting display panels are arranged side by side on the curved face.

The present invention is **characterized in that** an outer peripheral portion of the light-emitting display panel on the side of a display face is bonded to the curved face through an adhering member.

The present invention is **characterized in that** the adhering member is a light-shielding member.

The present invention is **characterized in that** an end-face light-shield member covering at least an end face of the light-emitting display EL panel is placed on the side of the light-emitting display panel.

The present invention is **characterized in that** a back-face light-shield member covering at least a back face of the light-emitting display panel is placed on the rear side of the substrate.

The present invention is **characterized in that** a light-shield layer is formed at least in a position of the curved face where the light-emitting display panel is not placed.

The present invention is **characterized in that** the light-shield layer is formed in a color which has a color difference ΔEab of 3 or lower (ΔEab ≤ 3) in the Lab color system from a color of the display face of the light-emitting display panel when no display is performed.

The present invention is **characterized in that** matte treatment achieving a haze value of 10% or lower is performed in a position of the curved face that is opposite to the light-emitting display panel with space interposed between them or in a position of the light-emitting display panel that is opposite to the curved face with space interposed between them.

The present invention is **characterized in that** the light-emitting display panel is formed of an organic EL panel provided by placing a functional layer including at least an organic light-emitting layer between a pair of electrodes on a support substrate.

The present invention is **characterized in that** the light-emitting display panel has a shape long in a direction in which the substrate is not curved and the plurality of the light-emitting display panels are arranged side by side along the curved face of the substrate.

The present invention is **characterized in that** the light-emitting display panels are placed such that a distance between adjacent two of the panels is 10 mm or smaller. Advantage of the Invention

The present invention relates to a light-emitting display apparatus having a curved display face which can be manufactured with ease and high yield.

### Brief Description of the Drawings

[Fig. 1] A perspective view showing a light-emitting display apparatus which is an embodiment of the present invention.
[Fig. 2] An enlarged section view showing the light-emitting display apparatus.
[Fig. 3] A diagram showing an organic EL panel of the light-emitting display apparatus.
[Fig. 4] A perspective view showing a light-emitting display apparatus which is another embodiment of the present invention.
[Fig. 5] A perspective view showing a light-emitting display apparatus which is another embodiment of the present invention.

### Mode for Carrying Out the Invention

Embodiments to which the present invention is applied will hereinafter be described with the accompanying drawings.

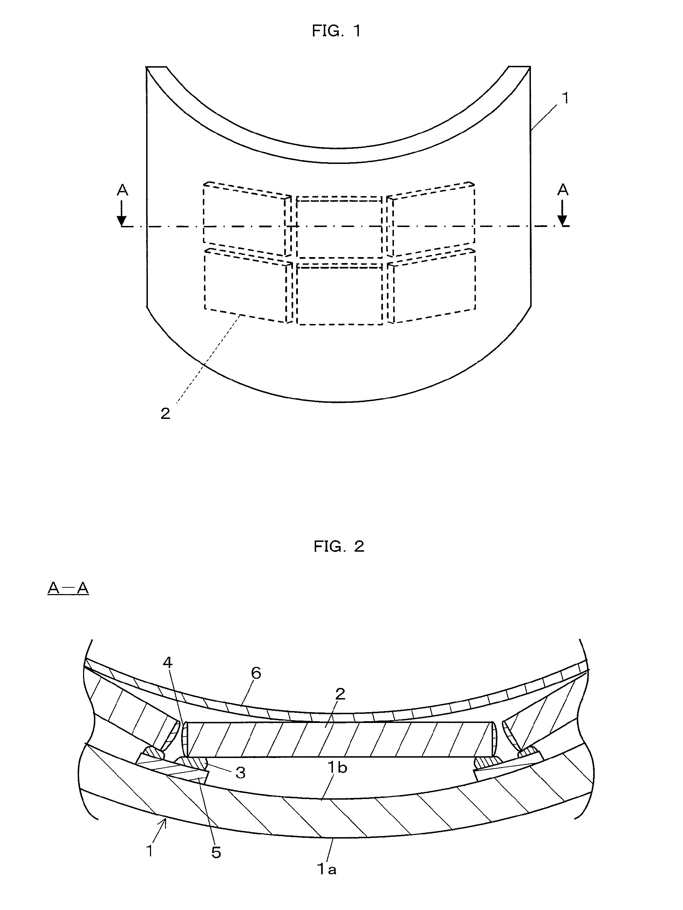

In Fig. 1 and Fig. 2, a light-emitting display apparatus which is an embodiment of the present invention includes a curved substrate 1, a plurality of organic EL panels (light-emitting display panels) 2, an adhering member 3, an end-face light-shield member 4, a masking layer (light-shield layer) 5, and a back-face light-shield member 6, and is provided by placing and fixing the plurality of organic EL panels 2 to a curved face of the substrate 1.

The substrate 1 is made of light-transmitting resin material and has a display face 1a facing a user and its back face 1b which are curved faces curved at a predetermined curvature. It is only required that the substrate 1 should have the light transmittance for transmitting display light from the organic EL panel 2, and the substrate 1 may be transparent or may be colored semitransparent with frosting or the like. When the substrate 1 is colored, the light transmittance appropriately ranges from approximately 5 to 50%.

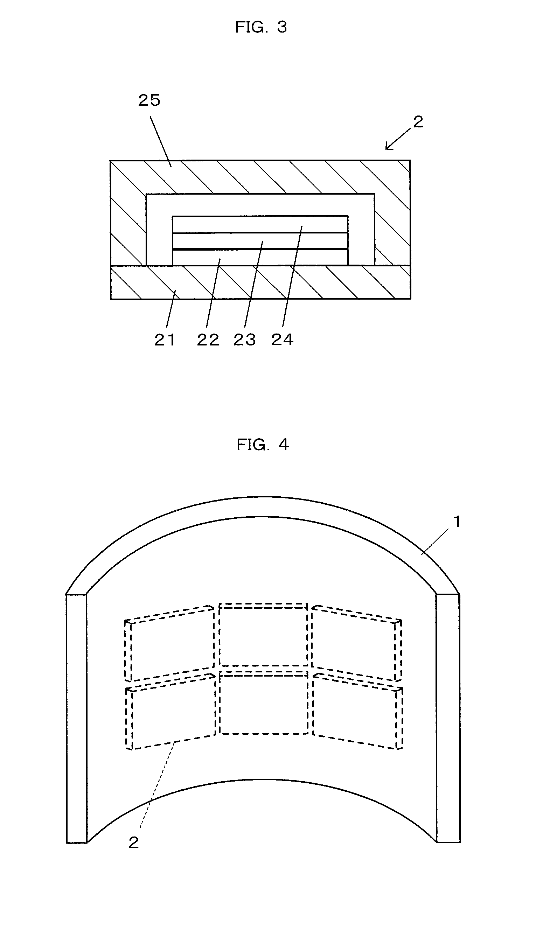

As shown in Fig. 3, the organic EL panel 2 includes an organic EL element provided by stacking a light-transmitting first electrode 22, a functional layer 23, and a second electrode 24 on a support substrate 21. The side of the support substrate 21 is used as a light-emitting display face (surface) from which the light transmitted through the first electrode 22 is taken. In the organic EL panel 2, a sealing member 25 of generally U-shape covering the organic EL element is bonded to the support substrate 21.

The support substrate 21 is a light-transmitting glass substrate of rectangular shape.

The first electrode 22 is provided by forming a light-transmitting conductive material such as ITO (Indium Tin Oxide) in layer on the support substrate 21 with a method such as sputtering and then patterning the material into a predetermined shape, for example with photolithography. In the present embodiment, the first electrode 22 serves as an anode and injects holes into the functional layer 23.

The functional layer 23 is formed on the first electrode 22 and includes a plurality of layers having at least an organic light-emitting layer. For example, in the present embodiment, the functional layer 23 is provided by sequentially stacking a hole injection layer, a hole transport layer, a first organic light-emitting layer, a second organic light-emitting layer, a first electron transport layer, a second electron transport layer, and an electron injection layer, with means such as evaporation.

The second electrode 24 is an electrode placed on the side opposite to the light-emitting display face and is provided by placing a low-resistance conductive material such as aluminum (Al) and magnesium-silver (Mg:Ag) into layer having a thickness of approximately 50 to 200 nm with means such as evaporation.

The sealing member 25 is bonded to the support substrate 21 through an adhesive, not shown, and is provided by forming flat glass into generally U-shape with a machining method such as cutting and etching, for example. The sealing member 25 covers the organic EL element together with the support substrate 21 and suppresses the deterioration of the organic EL element due to moisture or the like. It should be noted that a moisture absorber for absorbing moisture may be placed in the space surrounded by the sealing member 25.

The adhering member 3 is made of a photo-setting, thermo-setting, or anaerobic adhesive, for example. In addition, a sticky material such as silicone or a tape with sticky material may be used. The adhering member 3 is applied, filled, or placed between the outer peripheral portion of the organic EL panel 2 on the side of the display face (a non light-emitting portion surrounding a light-emitting display portion) and the back face 1b of the substrate 1 to fix the organic EL panel 2 to the back face 1b of the substrate 1. The adhering member 3 desirably shields light (does not transmit light) in order to prevent light from the organic EL panel 2 from leaking to the surroundings, and desirably contains a black-color material.

The end-face light-shield member 4 is made of light-shielding material similar to that of the adhering member 3, for example, and is provided to cover the end face of each organic EL panel 2. The end-face light-shield member 4 is provided for preventing light leakage from the end face of each organic EL panel 2. Alternatively, the adhering member 3 may be formed to reach the end face of each organic EL panel 2 and to double as the function of the end-face light-shield member.

The masking layer 5 is formed of a light-shielding printing layer formed at least in the position of the back face 1b of the substrate 1 where the organic EL panel 2 is not placed, and is provided by printing a non-transparent resin material, for example. In the present embodiment, the masking layer 5 is formed on the back face 1b of the substrate 1 at the position opposite to the outer peripheral portion of each organic EL panel 2 on the side of the display face and the position not opposite to each organic EL panel 2 to prevent the display light from the organic EL panel 2 from leaking to the outside from the surroundings of the light-emitting display portion. The masking layer 5 desirably has a color identical to the color of the light-emitting display face of the organic EL panel 2 (which is the color of a polarizing plate, if provided). Specifically, the masking layer 5 is preferably formed by using a material of a color which has a color difference ΔEab of 3 or lower (ΔEab ≤ 3) in the Lab color system from the color of the organic EL panel 2 when no display is performed, since the difference in color between the masking layer 5 and the light-emitting display face of the organic EL panel 2, that is, the boundary portion between the position of the substrate 1 where the organic EL panel 2 is placed and the position where the organic EL panel 2 is not placed is not recognized by the user.

The back-face light-shield member 6 is provided on the rear side of the substrate 1 and is formed of a black-color film with sticky material, a light-shielding paste, a light-shielding coating or the like. It is only required that the back-face light-shield member 6 should cover at least the back face of each organic EL panel 2, but in the present embodiment, the member 6 is formed to cover the overall back face 1b of the substrate 1.

The above mentioned components construct the light-emitting display apparatus.

In the present embodiment, the back face 1b of the substrate 1 is opposite to the position of the display face of the organic EL panel 2 where the light-emitting display portion is located with the space (gap) interposed between them, and Newton's rings may occur depending on the distance between them. In that case, matte treatment is desirably performed at least in the position of the back face 1b of the substrate 1 that is opposite to the organic EL panel 2 or the display face of the organic EL panel 2. Specifically, the matte treatment which achieves a haze value of 10% or lower (more desirably, 5% or lower) is preferably performed since it can prevent the occurrence of the Newton's rings and maintain the brightness of the display.

In such a light-emitting display apparatus, the user visually recognizes a light-emitting display image obtained by each organic EL panel 2 as if the image floated on the display face 1a of the substrate 1 which is the curved face. The use of the organic EL panel 2 of flat shape hardly causes the problems of the organic EL panel in durability and productivity and low yield as compared with the conventional method in which the flexible organic EL panel is used. Thus, it is possible to manufacture the light-emitting display apparatus having the curved face with ease and high yield.

In addition, the plurality of organic EL panels 2 are placed side by side on the back face 1b of the substrate 1, so that the light-emitting display image can be displayed along the curved display face 1a to improve the marketability.

Furthermore, since the outer peripheral portion of the organic EL panel 2 on the side of the display face is attached to the back face 1b of the substrate 1 through the adhering member 3 , the organic EL panel 2 of flat shape can be favorably placed and fixed to the back face 1b which is the curved face. In addition, the light-shielding adhering member 3 can be used to prevent the light from leaking to the surroundings to improve the display quality.

The placement of the end-face light-shield member 4 covering the end face of the organic EL panel on the side of the organic EL panel 2 prevents the light leakage from the end face to improve the display quality.

The placement of the back-face light-shield member 6 covering at least the back face of the organic EL panel 2 on the rear side of the substrate 1 prevents the incidence of external light to suppress a reduction in display quality.

The masking layer 5 is formed at least in the position of the back face 1b of the substrate 1 where the organic EL panel 2 is not placed, so that the display light from the organic EL panel 2 can be prevented from leaking to the outside from the surroundings of the light-emitting display portion to improve the display quality. The color of the masking layer 5 is set such that the color difference ΔEab is 3 or lower (ΔEab ≤ 3) in the Lab color system from the color of the display face of the organic EL panel 2 when no display is performed, so that the boundary portion between the organic EL panel 2 and the masking layer 5 is not recognized by the user, thereby making it possible to improve the unity of the entire light-emitting display apparatus.

The matte treatment with a haze value of 10% or lower can be performed in the position of the base face 1b of the substrate 1 that is opposite to the organic EL panel 2 with space interposed between them or the position of the organic EL panel 2 that is opposite to the back face 1b with the space interposed between them (at least the position of the back face 1b of the substrate 1 that is opposite to the organic EL panel 2 or the display face of the organic EL panel 2) to prevent the occurrence of the Newton's rings and maintain the brightness of the display.

While the display face 1a of the substrate 1 is formed in convex shape in the present embodiment, the display face of the present invention is not limited thereto. It is possible to employ a light-emitting display apparatus having a display face of concave shape, for example as shown in Fig. 4.

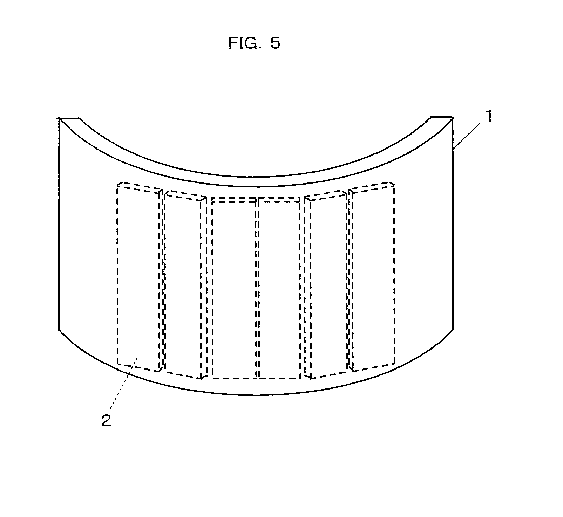

As shown in Fig. 5, in the light-emitting display apparatus of the present invention, the organic EL panel 2 may have a strip shape which is shorter in the direction in which the substrate 1 is curved and is longer in the direction in which the substrate 1 is not curved, and the plurality of organic EL panels 2 may be placed side by side in parallel with the uncurved side of the substrate 1 and along the back face 1b of the substrate 1. In such a structure, the distance between the organic EL panels 2 can be reduced, so that the display of the organic EL panels 2 can be integrally recognized visually to allow high-resolution display. The result of the investigation by the present inventor shows that an increase in the distance between the organic EL panels 2 (for example, approximately 30 mm) loses the unity of the light-emitting display images of the organic EL panels 2 and thus the distance between the organic EL panels 2 is desirably 10 mm or smaller in order to obtain the integral light-emitting display image along the curved display face 1a.

### Industrial Applicability

The present invention is preferably used for a light-emitting display apparatus including a curved display face. A liquid crystal display panel may be used as the light-emitting display panel, in addition to the organic EL panel.

### Description of Reference Numerals and Signs

- 1: SUBSTRATE

- 2: ORGANIC EL PANEL (LIGHT-EMITTING DISPLAY PANEL)
- 3: ADHERING MEMBER
- 4: END-FACE LIGHT-SHIELD MEMBER
- 5: MASKING LAYER (LIGHT-SHIELD LAYER)
- 6: BACK-FACE LIGHT-SHIELD MEMBER
- 21: SUPPORT SUBSTRATE
- 22: FIRST ELECTRODE
- 23: FUNCTIONAL LAYER
- 24: SECOND ELECTRODE
- 25: SEALING MEMBER

## Claims

1. A light-emitting display apparatus comprising a curved and light-transmitting substrate and a flat light-emitting display panel, **characterized in that** the light-emitting display panel is placed and fixed onto a curved face of the substrate.

2. The light-emitting display apparatus according to claim 1, **characterized in that** a plurality of the light-emitting display panels are arranged side by side on the curved face.

3. The light-emitting display apparatus according to claim 1, **characterized in that** an outer peripheral portion of the light-emitting display panel on the side of a display face is bonded to the curved face through an adhering member.

4. The light-emitting display apparatus according to claim 3, **characterized in that** the adhering member is a light-shielding member.

5. The light-emitting display apparatus according to claim 1, **characterized in that** an end-face light-shield member covering at least an end face of the light-emitting display EL panel is placed on the side of the light-emitting display panel.

6. The light-emitting display apparatus according to claim 1, **characterized in that** a back-face light-shield member covering at least a back face of the light-emitting display panel is placed on the rear side of the substrate.

7. The light-emitting display apparatus according to claim 1, **characterized in that** a light-shield layer is formed at least in a position of the curved face where the light-emitting display panel is not placed.

8. The light-emitting display apparatus according to claim 7, **characterized in that** the light-shield layer is formed in a color which has a color difference ΔEab of 3 or lower (ΔEab ≤ 3) in the Lab color system from a color of the display face of the light-emitting display panel when no display is performed.

9. The light-emitting display apparatus according to claim 1, **characterized in that** matte treatment achieving a haze value of 10% or lower is performed in a position of the curved face that is opposite to the light-emitting display panel with space interposed between them or in a position of the light-emitting display panel that is opposite to the curved face with space interposed between them.

10. The light-emitting display apparatus according to claim 1 , **characterized in that** the light-emitting display panel has a shape long in a direction in which the substrate is not curved and the plurality of the light-emitting display panels are arranged side by side along the curved face of the substrate.

11. The light-emitting display apparatus according to claim 2 or 10, **characterized in that** the light-emitting display panels are placed such that a distance between adjacent two of the panels is 10 mm or smaller.

12. The light-emitting display apparatus according to claim 1, **characterized in that** the light-emitting display panel is formed of an organic EL panel provided by placing a functional layer including at least an organic light-emitting layer between a pair of electrodes on a support substrate.
